# EUROPEAN PATENT APPLICATION

(11) **EP 3 166 371 A1**
(43) Date of publication of application: **10.05.2017**
(21) Application number: 15203047.4
(22) Date of filing: 30.12.2015
(51) Int. Cl.: H05K 1/18, H05K 3/34

(54) **SOLAR LAMP, PCB CIRCUIT FOR THE SOLAR LAMP AND A PREPARATION METHOD THEREOF**

(30) Priority: 05.11.2015 CN 201510744794
(71) Applicant: Fujian Joy Solar Technology Corporation, Quanzhou Fujian (CN)
(72) Inventor: CHEN, Guangyan, Quanzhou Fujian (CN)
(74) Representative: Karaahmet, Erdogan

(57) **Abstract**

A PCB adaptation for a solar lamp, characterized in that, at least one slot is set on the PCB, both sides of the slot comprises a pad, the pad connects to an inner circuit on the PCB, two leads of a leaded component is respectively soldered to the pad, which is located on both sides of the slot. By cutting a slot on the PCB in the present invention, auto surface-mount technology can be implemented to automatically solder the leaded component to the PCB. Low-cost leaded component and surface-mount technology are used in above technical solution, which can decrease the cost and increase the productivity and product quality.

## Description

### TECHNICAL FIELD

This invention relates to the technical field of Printed Circuit Board (PCB), particularly relates to a solar lamp, a PCB for the solar lamp and a preparation method thereof.

### BACKGROUND

The solar lamp is made of solar module (solar panel), ultra-bright LED (illuminant), maintenance-free rechargeable battery, auto-control circuit (PCB), lighting fixture etc. The solar lamp is powered by the solar panel. When sunlight is projected onto the solar panel in the daytime, the light energy will be converted into electric energy to be stored in the battery, and then the battery will power the LED (Light Emitting Diode) of lawn lamp at night. Said solar lamp has the advantages of being safe, energy saving, convenience, being environmentally friendly etc. and can be applied as a lighting or a decoration for the lawn of residential communities or parks.

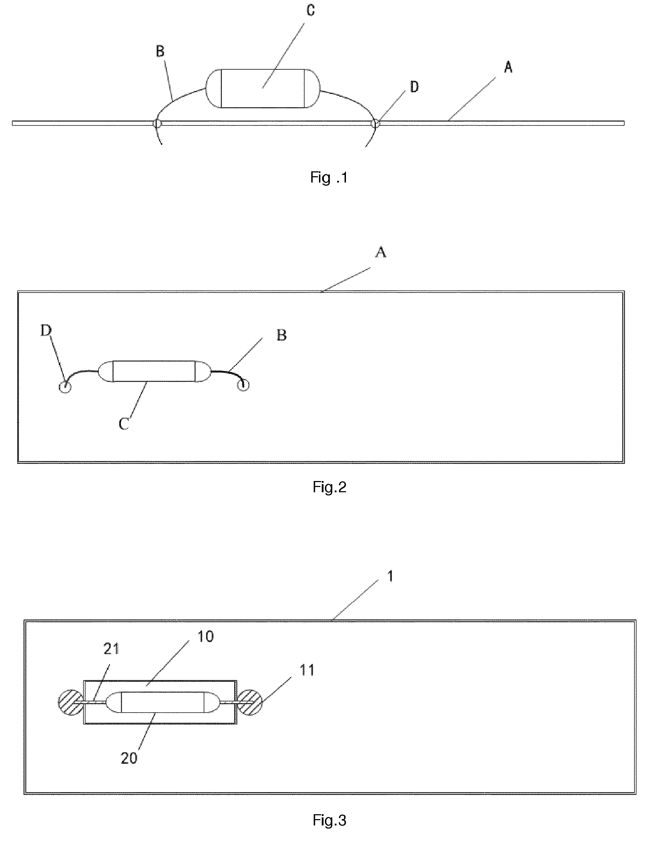

Currently, the main expenses of the solar lamp are raw material cost and production cost, and the production cost is mainly in the preparation of PCB and assembly for the circuit board and other modules (like solar panel). There are two methods for mounting electronic components to a PCB currently. First is auto surface-mount technology, which uses the automatic equipment to automatically assemble the surface-mount component (SMC). The other is through-hole technology, referring to Fig.1 and Fig.2, the existing leaded component C comprises lead B, and there are holes D drilled on the PCB. The leads of the leaded component are inserted into the holes by manual assembly, because the leads are made of soft material and they are difficult to be controlled.

It would increase the productivity to use the auto surface-mount technology, but the production cost for surface-mount component is higher, and under particular conditions, such as cases where a large-size electronic component is required or cooperation with the PCB layout design is present, the surface-mount technology cannot be used and only traditional through-hole technology is suitable. It costs less if through-hole technology is used, but the through-hole needs more manual work and as a result raises the production cost. Besides, it is easy to render the mounted electronic component uneven by hand placement, and raise the risk of short circuit of the leads as well.

### SUMMARY OF THE INVENTION

In order to solve above problems of having to use the through-hole technology under particular conditions, this invention provides a solar lamp, a PCB for the solar lamp and a preparation thereof, thereby increasing the productivity and production quality of the solar lamp under the condition of controlling the cost.

In a first aspect, this invention provides a PCB for solar lamp. Said PCB comprises at least one slot, and both sides of said slot comprises pads, wherein said pads connect to the inner circuit on the PCB respectively. The two leads of leaded component are respectively soldered to the pads located on both sides of the slot.

In the first possible implementation of the first aspect, the slot is placed at the margin of the PCB.

In the second possible implementation of the first aspect, a spacing board is placed on the bottom of the slot, wherein the height of the spacing board is no more than that of the bottom of said leaded component.

In the third possible implementation of the first aspect, both sides of the slot comprise a half-open groove respectively. The pads are placed on the half-open groove respectively, wherein the height of the pad is no more than the height of said PCB.

According to any implementation of the first aspect to the third possible implementation of the first aspect mentioned above, in the fourth possible implementation of the first aspect, the outlet of the light emitted from the surface-mount LED component located on the PCB comprises a loudspeaker structure.

In a second aspect, this invention further provides a preparation method for the PCB adapting to the solar lamp, comprising:
cutting on the PCB to form a slot;
printing solder paste onto the pads, which are placed on both sides of the slot;
sticking the leads of the leaded component onto the pads which are placed on both sides of the slot;
melting the solder paste, which is placed on the pads due to high temperature generated by reflow soldering so that the leaded component is firmly soldered to the PCB after cooling down.

In the first possible implementation of the second aspect, wherein after the step of cutting on the PCB to form a slot, it further comprises:
placing a spacing board at the bottom of the slot according to the bottom level of the mounting position of the leaded component.

In the second possible implementation of the second aspect, wherein the step of sticking the leads of the leaded component onto the pads further comprises:
shaping the leads of the leaded component by an auto shaping machine so that each leaded component has the same size;
taping the shaped leaded component;
sucking the plurality of the above leaded components by a vacuum suction nozzle of an automatic surface mounting machine, then scanning an image and rectifying the sucking deviation of the leaded component, and mounting the leaded component onto the slot of the PCB.

In a third aspect, this invention further provides a solar lamp, comprising solar panel, a circuit board for controlling the illumination, and battery, wherein the circuit board for controlling the illumination uses any one of the PCBs for solar lamp from the first aspect to the fourth possible implementation of the first aspect.

The first possible implementation of the third aspect, further comprising:
an auto-assembling plate trough, both sides of which respectively comprise a solar panel holding groove and a PCB holding groove, wherein the solar panel holding groove further comprises a convex at the bottom, and a channel is set between the solar panel holding groove and the PCB holding groove;
the solar panel is placed on the solar panel holding groove of the auto-assembling plate trough, wherein the face side of the solar panel faces towards the outside of the auto-assembling plate trough, and the back side of the solar panel faces towards the inside of the auto-assembling plate trough. An anode/cathode access point is set on the back side of the solar panel in the cover range of the channel of the auto-assembling plate trough;
the PCB is placed on the PCB holding groove of the auto-assembling plate trough, wherein the face side of the PCB faces towards the outside of the auto-assembling plate trough, and the back side of the PCB faces towards the inside of the auto-assembling plate trough. An "L" shaped anode/cathode plate is set on a power access point, which is located on the back side of the PCB in the cover range of the channel of the auto-assembling plate trough. The "L" shaped anode/cathode plate are respectfully connected to the anode/cathode access point of the solar panel. By cutting a slot on the PCB, this invention provides a method to use the auto surface-mount technology to automatically solder the leaded component to the PCB. The above technical solution uses the lower cost leaded component and the auto surface-mount technology, which can not only save cost, but also increase the productivity and product quality.

### BRIEF DESCRIPTION OF THE DRAWINGS

In order to more clearly descript this invention or the technical solution in existing technical knowledge, hereinafter, the necessary drawings in this invention or the existing technical knowledge will be described briefly. Obviously, while below drawings and description are some embodiments of this invention, a skilled person in the art can achieve other modified drawings according to below drawings without creative effort.
Fig.1 illustrates the front view of an existing PCB, which uses leaded component.
Fig.2 illustrates the plain view of the existing PCB, which uses leaded component.
Fig.3 illustrates the schematic diagram of an embodiment of a PCB adaptation for a solar lamp.
Fig.4 illustrates the schematic diagram of another embodiment of a PCB adaptation for a solar lamp.
Fig.5 illustrates the schematic diagram of another embodiment of a PCB adaptation for a solar lamp.
Fig.6 illustrates the schematic diagram of another embodiment of a PCB adaptation for a solar lamp.
Fig.7 illustrates the schematic diagram of another embodiment of a PCB adaptation for a solar lamp.
Fig.8 illustrates the flowchart of a preparation method for a PCB adaptation for a solar lamp.
Fig.9 illustrates the flowchart of another preparation method for a PCB adaptation for a solar lamp.
Fig.10 illustrates the schematic diagram of an embodiment of the solar lamp in this invention.
Fig.11 illustrates the schematic diagram of a solar panel and the PCB illustrated in Fig.10.

### Reference Number:

- 1:: PCB
- 2:: Solar Panel
- 3:: Battery
- 5:: Auto-assembling plate trough
- 10:: Slot
- 11:: Pad
- 12:: Half-open groove
- 20:: Leaded component
- 21:: Lead
- 30:: Spacing board
- 40:: LED component
- 41:: Light outlet
- 51:: Solar panel holding groove
- 52:: PCB holding groove
- 53:: L shaped anode/cathode plate
- 54:: Power access point
- 55:: Anode/cathode access point
- 56:: Channel
- 57:: Convex

### DETAILED DESCRIPTION OF THE INVENTION

In order to more clearly describe the purpose, technical solution and advantage of this invention, hereinafter this invention will be described clearly and in detail in conjunction with the drawings. It is apparent that the description is merely a preferred embodiment of the present invention. Based on the described embodiment, one of ordinary skill in the art may make other modified embodiments without creative effort, and therefore those should fall within the protection scope of the present invention.

This invention provides a PCB. Fig.3 shows a schematic diagram of an embodiment of a PCB adaptation for a solar lamp, as shown in Fig.3. This embodiment provides PCB 1 on which at least one slot 10 is set; both sides of the slot 10 comprise pads 11 respectively, and pads 11 connect to the inner circuit of PCB 1 respectively. Two leads 21 of leaded component 20 are respectively soldered to pads 11 located on both sides of said slot 10. The number of the slot in above design can be determined by the number of the required leaded component.

In the existing technology, even though the surface-mount component can save the human cost in the mounting process, it requires higher production cost than the leaded component; therefore, considering cost saving, most of the manufacturers intend to use the leaded component when there are lots of components needed. In some particular conditions (such as, cases where a large-sized electronic component is required or there is cooperation with the PCB layout design), the leaded component should be adopted, such as high-capacity capacitance and inductance. Larger the parameter of the high-capacity capacitance and inductance, the larger the size they own. It is very hard for big-sized components to be surface mounted, since the leaded component would need extra hand placement. By setting more than one slot of the above PCB structure, the leaded component can be auto surface-mounted. By that means, expense is reduced and productivity is increased, and the quality problem caused by hand placement is avoided as well.

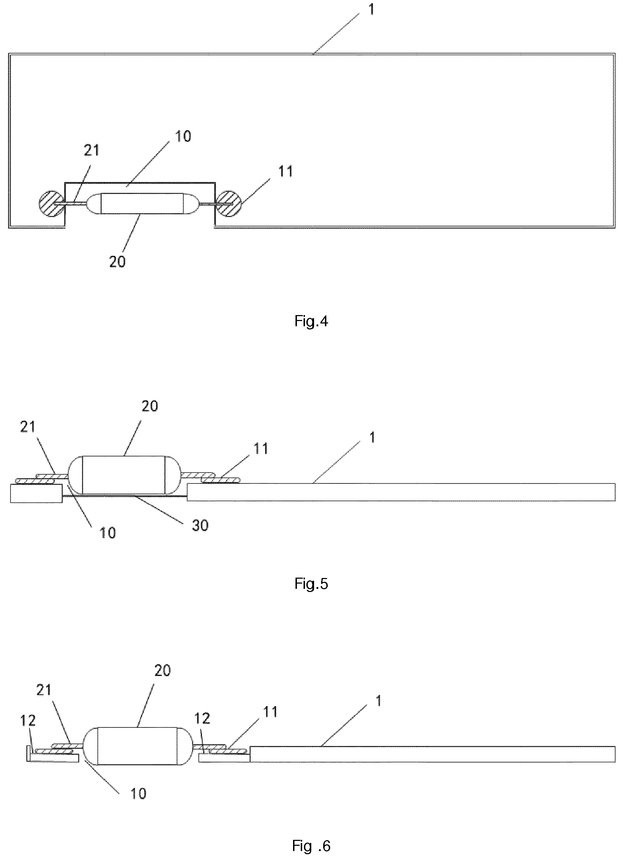

Fig.4 shows the schematic diagram of another embodiment of a PCB adaptation for a solar lamp. As shown in Fig.4, in order to meet the requirement of auto surface-mount technology, in this embodiment, slot 10 is set at the margin of PCB 1. Setting the slot at the margin of PCB can benefit the cutting process to form a slot and better controlling for the auto surface mounting can be achieved. Of course, there is no restriction for the position of the slot. It can be set according to the PCB layout and the design while auto surface mounting.

Fig.5 shows the schematic diagram of another embodiment of a PCB adaptation for a solar lamp. As shown in Fig.5, in that embodiment, the placing board 30 is placed at the bottom of slot 10. The height of said placing board 30 is no more than the bottom level of the leaded component 20.

In the above embodiment, the purpose of setting a placing board is as follows:
(1) If the bottom level of the leaded component is lower than the bottom of the PCB, it would render the leaded component to be lifted when its bottom contacts the assembling platform in the process of auto surface mounting. As a result, the two leads of the leaded components would not be in close contact with the pads. Placing a spacing board at the bottom and wherein the height of the spacing board is no more than the bottom level of the leaded component, and the spacing board is placed on the assembling platform, the leaded component is placed on the spacing board, above problems can be avoided.
(2) If the bottom level of the leaded component is higher than the bottom of the PCB, the leaded component would sink into the assembling platform. When it suffers possible outer pressure, it would render the fracture of the leads of the leaded component and make it useless. Placing a spacing board at the bottom, and wherein the height of the spacing board equals to or is slightly greater than the bottom level of the leaded component, and the leaded component is placed on the spacing board, above problems can be avoided.

Fig.6 shows the schematic diagram of another embodiment of a PCB adaptation for a solar lamp. As shown in Fig.6, half-open groove 12 is set on the both sides of the slot. Said 11 pads are placed on the half-open groove 12, wherein the height of said pad 11 is no more than that of PCB 1. Setting a half-open groove there has the advantage that the two leads of the leaded component can fall within the groove naturally when auto mounting. Benefit from such structure, even the solder paste fails to paste the leads very well, is that the leads would not cause the leads to break away from the pads on account of its back and forth moving.

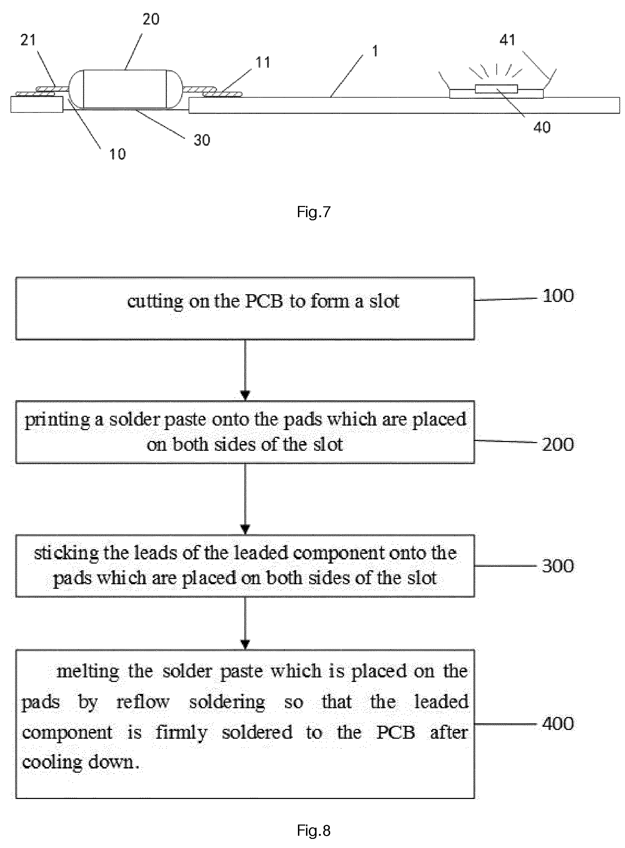

Fig.7 shows the schematic diagram of another embodiment of a PCB adaptation for a solar lamp. As shown in Fig.7, light outlet 41 of the surface mounted LED component on the PCB 1 comprises a loudspeaker structure. If leaded lamp is used, because of the length of its leads, the leaded lamp can be 10mm-20mm higher than the PCB when mounted it on the PCB. Therefore, after mounting the PCB to the structural part (plastic or metal case), the light source can be exposed to the outside of the structural part. However if the surface-mounted LED is used, due to the reason that the surface-mounted LED can only be mounted on the surface of the PCB, the emitted light will be shielded by the structural part, whereas if the LED light outlet is formed as a loudspeaker structure, it can protect the light from being shielded, and provide the light brightness more effectively.

This invention further provides a preparation method for the PCB. Fig. 8 illustrates the flowchart of a preparation method for a PCB adaptation for a solar lamp, as shown in Fig. 8, comprising the steps of:
Step 100: cutting on the PCB to form slot;

In this step, CNC (Computer Numerical Control) is used to make the slot automatically or die cutting is used to cut the slot. The inner circuit on the PCB should be designed to avoid the slot to protect its integrity. The specific position and size of the slot can be determined by the required size and mounting position of the electronic component.

When processing the PCB in the above step, it is required to reserve a position for the pads on the both sides of the slot. Said pads electrically connect to the inner circuit of the PCB respectively. The preparation process of the pad is as follows: At the beginning of the preparation, the copper clad laminate (CCL) of the PCB, which is a copper foil covering on the insulating material completely is used. Circuit and the pads on the sheet copper are designed by ink printing, and then is put into the FeCl₃ solution to etch the copper without being covered by the printed ink. For the last step, the printed ink covering the copper is cleaned to obtain the copper circuit and pads.

Step 200: printing solder paste onto the pads, which is placed on both sides of the slot;

In this step, auto-printing machine can be used. Said solder paste is mainly made by mixing and grinding metal powder (Tin) and soldering flux. It is a cream object with sticky character, and it can be melted and form tin point under high-temperature conditions.

Step 300: sticking the leads of the leaded component onto the pads, which are placed on both sides of the slot;

In this step, auto surface mounting machine can be used. The component can be temporarily stuck on the PCB, because the tin paste is something sticky.

Step 400: melting the solder paste, which is placed on the pads due to high temperature generated by reflow soldering, so that the leaded component is firmly soldered to the PCB after cooling down.

After all the components are assembled, the tin paste would be melted by reflow soldering to form the conductive tin point, which is in metallic state. After cooling down, the components and the PCB would be tightly bonded together and it is not easy to be broken away.

In above technical solution, particularly step 300, can comprise:
a. shaping the leads of the leaded components by auto shaping machine, so that each of the components can have the same size. This would have the advantage of reducing the deviation for the surface mounting machine to recognize the shape of the components. The more consistent the shape of the components are, the more accurate the surface mounting.
b. taping the shaped leaded component, so that the surface mounting machine can be uninterruptedly and quickly reclaimed in the later stage.
c. sucking the plurality of the above leaded components by a vacuum suction nozzle of an automatic surface mounting machine, then scanning an image and rectifying a sucking deviation of the leaded component; then, mounting the leaded component onto the slot of the PCB: In this step, because the length of the two leads of the electronic component is greater than that of the slot, the leads would be placed on the pads, which are located on both sides of the slot. Since tin paste is sticky, the electronical component would temporarily be placed on the PCB without moving.

It is apparent in above description that, all of the above steps can be implemented by automatic machines. Therefore, through the steps of 100∼400, it can be realistic to automatically surface mount the lower-cost leaded component. This also avoids the problems of low productivity, high-cost and unsecured product quality caused by the manual work.

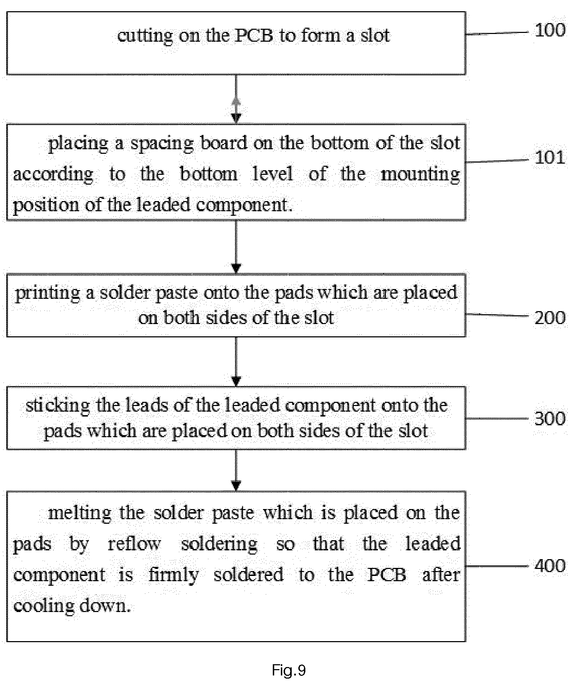

Fig.9 illustrates the flowchart of another preparation method for a PCB adaptation for a solar lamp. Compared to Fig.8, this embodiment adds a step 101 after Step 100, by placing a spacing board at the bottom of the slot according to the bottom level of the assembling position of the leaded component. The purpose and meaning of setting a spacing board has been described in detail in the embodiment shown in Fig.5; therefore, it is not going to be repeated here.

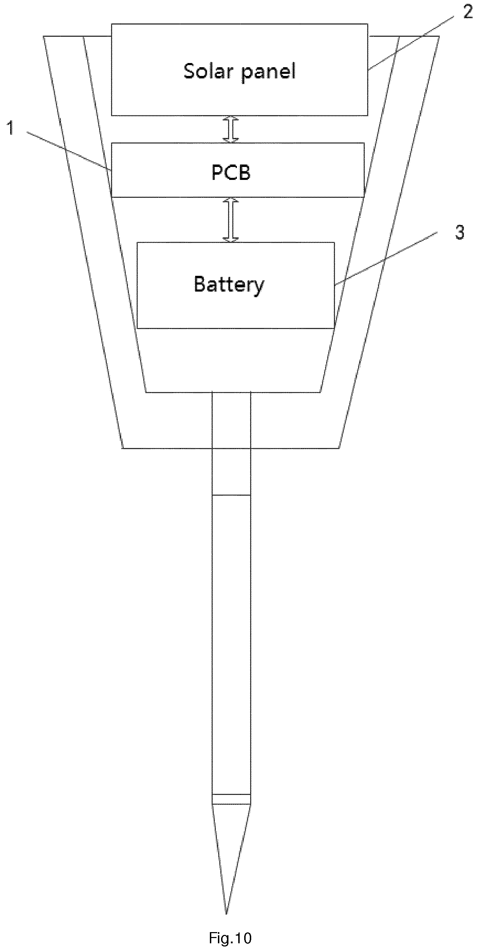

This invention further provides a solar lamp. Fig.10 illustrates the schematic diagram of an embodiment of the solar lamp in this invention. As shown in Fig.10, the solar lamp can comprise solar panel 2, lighting-control circuit 1 and battery 3, wherein the PCB for the solar lamp as shown in any of Fig3∼ Fig7 is used in the lighting-control circuit.

Wherein, the PCB can further comprise core components such as inductor, IC, LED, the working principle of this embodiment is that, in the daytime, the sun light is converted to electric energy and then charges the battery through IC. After the battery is fully charged, the IC cuts off the electric connection of the solar panel for conservation. At this time, the electric energy converted from the solar energy is merely used to provide a "daytime" signal for the IC and the system is in standby mode. Electric energy of the solar panel disappears at night, and then the IC starts charging (i.e. boosting the voltage) the inductor. It then drives the LED illumination.

Compared to the products in the market, for a variety of reasons, core component IC, inductor and LED are through-hole mounted. It is quite hard to control the fault rate, cost, and quality of the product. However, the provided solar lamp in this inventive embodiment can use the PCB as shown in Fig.3∼ Fig.7, in conjunction with the preparation method as shown in Fig.8 or Fig.9. As a result, the leaded component (like inductor) can be shaped and retaped, and it can use the surface-mount machine to surface mount it. Such an assembly method has the advantages of high effectivity, low cost and secure quality, etc..

Furthermore, while conducting a surface mounting of the LED, the feature that light outlet of the surface mounted LED component on the PCB 1 comprising a loudspeaker structure as shown in Fig.7 can be used. Therefore, the illuminant can be projected out with direction, and obtain a higher consistency of the illuminance.

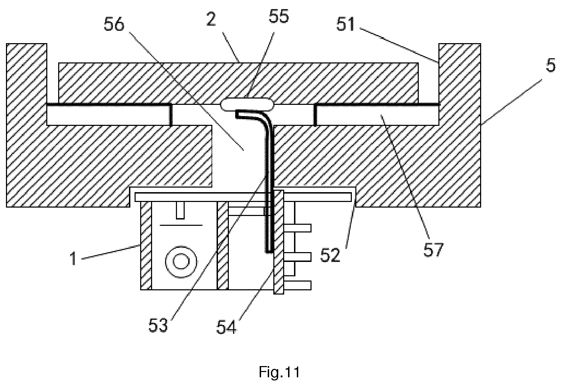

In order to further improve the degree of auto assembly, based on above structure, an auto-assembling plate trough is added. Referring to Fig.11, the structure comprises:
an auto-assembling plate trough 5, both sides of which respectively comprise a solar panel holding groove 51 and a PCB holding groove 52, wherein the solar panel holding groove 51 further comprises a convex 57 at the bottom, and a channel 56 is set between the solar panel holding groove 51 and the PCB holding groove 52;
solar panel 2 is placed on the solar panel holding groove 51 of the auto-assembling plate trough 5, wherein the face side of the solar panel 2 faces towards the outside of the auto-assembling plate trough 5, and the back side of the solar panel 2 faces towards the inside of the auto-assembling plate trough 5. At least one anode/cathode access point 55 is set on the back side of the solar panel 2 in the coverage of the channel 56 of the auto-assembling plate trough 5;
the PCB 1 is placed inside the PCB holding groove 52 of the auto-assembling plate trough 5, wherein the face side of the PCB 1 faces towards the outside of the auto-assembling plate trough 5, and the back side of the PCB 1 faces towards the inside of the auto-assembling plate trough 5. The "L" shaped anode/cathode plate 53 is set on a power access point 54, which is located on the back side of the PCB 1 in the coverage of the channel 56 of the auto-assembling plate trough 5. The "L" shaped anode/cathode plates are respectfully connected to the anode/cathode access point of the solar panel.

Traditional solar panel connects to the PCB by soft wires. Because of the hard-control of the characteristic of the wires in the preparation process, for example, manual work is needed for soldering the anode/cathode wire to the PCB during the implementing process and manually soldering the anode/cathode wire to the PCB after fixing the solar panel and the PCB. In addition, it is required to spray adhesive material on the solar panel for sticking, because the wires are soft and hard to control. The process of pasting the wire also needs manual work. This would definitely reduce the productivity and increase the cost. However, polar plate is used in above technical solution. It can allow a better control of the process, increase the productivity, and reduce the production cost largely.

The preparation process used is as follows:
(1) spraying the glass cement on the solar panel supporting groove by using an auto dispenser;
(2) assembling the solar panel in the solar panel supporting groove by using an auto assembling machine, and through the glass cement sprayed in step (1), the solar panel can be bonded to the solar panel supporting groove;
(3) assembling the PCB in the PCB supporting groove by using an auto assembling machine.
   At this time, the L shaped anode/cathode plate of the PCB goes through the channel and electrically connects to the anode/cathode access point of the solar panel, so that the electric energy converted from the solar energy can be transmitted to the PCB. As a result, the circuit is controlled.
   In order to enhance the reliability of the connection between the L-shaped anode/cathode plate and the anode/cathode access point on the solar panel, the following steps can be added:
(4) soldering tin is used to connect the L shape anode/cathode plate of the PCB with the anode/cathode access point of the solar panel by using an auto tin soldering machine.

Apparent from the above steps, when manufacturing the solar lamp as shown in Fig.10, automatic equipment (like auto surface mounting machine, auto dispenser and auto tin soldering machine) can be used to prepare the PCB and assemble the solar panel and the PCB. Therefore, the productivity of the solar lamp can be effectively increased, manual work can be reduced, and the production cost can be saved.

At last, the above merely describes the technical solution of this invention, and does not intend to limit the scope of the present invention. Those skilled in the art should understand that equivalent replacement or modifications can be made based on the principles of the present invention. However, all such modifications and replacements do not depart from the principle, and therefore shall fall within the scope of the present invention.

## Claims

1. A PCB adaptation for a solar lamp, **characterized in that**, at least one slot is set on the PCB, both sides of the slot comprises a plurality of pads, the plurality of pads respectfully connect to an inner circuit on the PCB, two leads of a leaded component is respectively soldered to the plurality of pads, which are located on both sides of the slot.

2. The PCB adaptation for the solar lamp according to claim 1, **characterized in that**, the slot is set at the margin of the PCB.

3. The PCB adaptation for the solar lamp according to claim 1, **characterized in that**, a spacing board is placed at the bottom of the slot, wherein the height of the spacing board is no more than the bottom level of the leaded component.

4. The PCB adaptation for the solar lamp according to claim 1, **characterized in that**, both sides of the slot comprises a half-open groove, the pad is placed on the half-open groove, wherein the height of the pad is no more than that of the PCB.

5. The PCB adapting for the solar lamp according to any of claims 1-4, **characterized in that**, a light outlet of a surface mounted LED component on the PCB comprises a loudspeaker structure.

6. A preparation method of a PCB adapting for a solar lamp, **characterized in that**, comprising:
cutting on the PCB to form a slot;
printing a solder paste onto a plurality of pads which are placed on both sides of the slot;
sticking the leads of the leaded component onto the plurality of pads which are placed on both sides of the slot;
melting the solder paste, which is placed on the plurality of pads, by reflow soldering so that the leaded component is firmly soldered to the PCB after cooling down.

7. The preparation method for the PCB adaptation for the solar lamp according to claim 6, **characterized in that**, after the step of cutting on the PCB to form a slot, it further comprises:
placing a spacing board at the bottom of the slot according to the bottom level of the mounting position of the leaded component.

8. The preparation method for the PCB adaptation for the solar lamp according to claim 6, **characterized in that**, the step of sticking the leads of the leaded component onto the plurality of pads, which are placed on both sides of the slot, comprises:
shaping the leads of a plurality of leaded components by an auto shaping machine so that the plurality of the leaded components have the same size;
taping the plurality of the leaded components after shaping;
sucking the plurality of the above leaded components by a vacuum suction nozzle of an automatic surface mounting machine;
scanning an image;
rectifying a sucking deviation of the leaded component;
mounting the leaded component onto the slot of the PCB.

9. A solar lamp, comprising a solar panel, a lighting-control circuit and a battery, **characterized in that**, the lighting-control circuit uses the PCB, which is adapted for the solar lamp according to claims 1-5.

10. The solar lamp according to claim 9, **characterized in that**, it further comprises:
an auto-assembling plate trough, both sides of which respectively comprise a solar panel holding groove and a PCB holding groove, wherein the solar panel holding groove further comprises a convex on the bottom, and a channel is set between the solar panel holding groove and the PCB holding groove;
the solar panel is placed on the solar panel holding groove of the auto-assembling plate trough, wherein the face side of the solar panel faces towards the outside of the auto-assembling plate trough, and the back side of the solar panel faces towards the inside of the auto-assembling plate trough, and at least one anode/cathode access point is set on the back side of the solar panel in the coverage of the channel of the auto-assembling plate trough;
the PCB is placed on the PCB holding groove of the auto-assembling plate trough, wherein the face side of the PCB faces towards the outside of the auto-assembling plate trough, and the back side of the PCB faces towards the inside of the auto-assembling plate trough, an "L" shaped anode/cathode plate is set on a power access point, which is located on the back side of the PCB in the coverage of the channel of the auto-assembling plate trough, the "L" shaped anode/cathode plates are respectfully connected to the anode/cathode access point of the solar panel.
